Europäisches Patentamt

European Patent Office

Office européen des brevets

(11) Veröffentlichungsnummer: **0 280 061 B1**

(12) **EUROPÄISCHE PATENTSCHRIFT**

(45) Veröffentlichungstag der Patentschrift: **19.08.92**

(21) Anmeldenummer: **88101216.5**

(22) Anmeldetag: **28.01.88**

(51) Int. Cl.⁵: **H05K 5/00**

(54) **Klappbare Halterung für ein tragbares Bediengerät.**

(30) Priorität: **21.02.87 DE 3705597**

(43) Veröffentlichungstag der Anmeldung:
**31.08.88 Patentblatt 88/35**

(45) Bekanntmachung des Hinweises auf die
Patenterteilung:
**19.08.92 Patentblatt 92/34**

(84) Benannte Vertragsstaaten:
**AT DE FR LU**

(56) Entgegenhaltungen:
**DE-U- 1 965 257**
**DE-U- 1 985 025**
**DE-U- 8 006 764**

(73) Patentinhaber: **Licentia Patent-**
**Verwaltungs-GmbH**
**Theodor-Stern-Kai 1**
**W-6000 Frankfurt/Main 70(DE)**

(84) Benannte Vertragsstaaten:
**AT DE FR LU**

(73) Patentinhaber: **DEUTSCHE BUNDESBAHN**
**Bundesbahn-Zentralamt Minden (Westf.) We-**
**serglacis 2**
**W-4950 Minden(DE)**

(84) Benannte Vertragsstaaten:
**DE**

(72) Erfinder: **Weinberger, Karl, Ing. grad.**
**Weichselgartenstrasse 13**
**W-8000 München 71(DE)**
Erfinder: **Karl,Werner,Dipl.-Ing.(FH)**
**Bäumlstrasse 45**
**W-8039 Puchheim(DE)**

(74) Vertreter: **Amersbach, Werner, Dipl.-Ing. et al**
**Licentia Patent-Verwaltungs-GmbH Theodor-**
**Stern-Kai 1**
**W-6000 Frankfurt 70(DE)**

# Beschreibung

Klappbare Halterung für ein tragbares Bediengerät und Kombination einer solchen Halterung und eines Bediengeräts.

Die Erfindung betrifft eine Halterung für ein tragbares Bediengerät sowie die Kombination einer solchen Halterung und eines Bediengeräts. Zwar wird im folgenden die erfindungsgemäße Halterung im Zusammenhang mit Sprechfunkgeräten beschrieben, doch ist die Erfindung nicht auf diesen Anwendungsfall beschränkt. Vielmehr kann die Erfindung ganz allgemein bei tragbaren Bediengeräten, wie z.B. tragbaren Datenmaterials, tragbaren Rechnern oder tragbaren Meßgeräten, verwendet werden.

Moderne Sprechfunkgeräte sind oft so gestaltet, daß sie eine Bedientastatur und Anzeigeelemente am vorderen Gehäuseteil aufweisen. Der Anwender hält das Gerät in einer Hand, wobei diese Bedien- und Anzeigeelemente zum Gesicht des Anwenders zeigen. Trägt der Benutzer das Gerät in einem Tragegeschirr am Körper - es ist bekannt, Handsprechfunkgeräte oder Datenfunkterminals in Tragegeschirren zu tragen - so sind Bedientastatur und Anzeige nicht zugänglich.

Aufgabe der vorliegenden Erfindung ist es, für tragbare Bediengeräte der vorstehend beschriebenen Art eine Halterung, die die Bedienbarkeit der im Tragegeschirr befindlichen Geräte ermöglicht, sowie eine Kombination einer solchen Halterung mit einem Bediengerät anzugeben.

Die erfindungsgemäße Halterung ist im Patentanspruch 1 angegeben. Die Ansprüche 2 bis 4 beschreiben Kombinationen dieser Halterung mit einem Bediengerät.
Die Erfindung wird im folgenden anhand eines in den Figuren dargestellten Ausführungsbeispiel näher erläutert.

Ein Handsprechfunkgerät 1 steckt in einer klappbaren Halterung. Das Gerät wird mit einem Tragegeschirr 6 am Körper - an der Brust oder an der Schulter - getragen. Die Halterung besteht aus einem Teil 4, welches am Tragegeschirr 6 befestigt ist, und einem mittels Scharnier 5 bei Bedarf wegklappbaren zweiten halbscheibenförmigen Teil 3, in welchem das Funkgerät 1 steckt.

Figur 1 zeigt den zusammengeklappten Zustand, in dem die Bedienelemente geschützt sind. Sprechfunkbetrieb ist in diesem Zustand möglich, da sich Lautsprecher und Mikrophon üblicherweise oben im Gerät befinden, und die Sprech-/Ruftasten seitlich oben am Gerät.

Figur 2 zeigt den aufgeklappten Zustand (zwischen 60° und 90°), bei dem die Bedien- und Anzeigeelemente sichtbar und bedienbar sind.

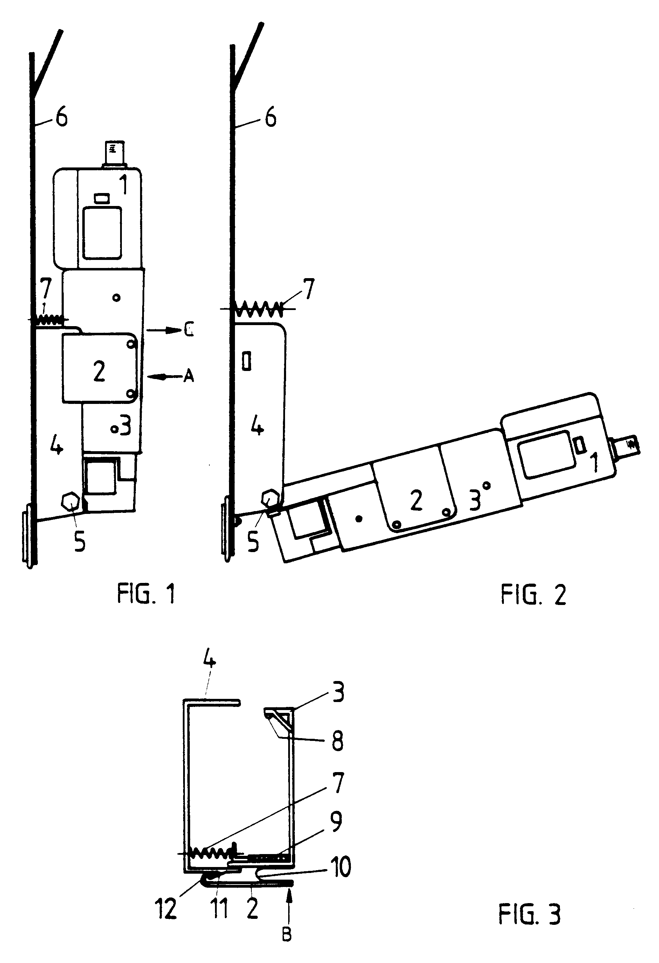

Figur 3 zeigt einen Schnitt durch die Halterung. Der Verriegelungsmechanismus ist so ausgebildet, daß eine unbeabsichtigte Entriegelung ausgeschlossen ist, aber Einhandbedienung, auch mit groben Handschuhen, möglich ist. Das zweite Teil 3 weist an einer Außenseite eine großflächige Verriegelungsklappe 2 auf, welche gegen den Druck einer ersten Feder 10 (in Richtung B) zu betätigen ist. Sie greift mit einem Bogen 12 in einen Haken 11 des ersten Teils 4. Eine zweite Feder 7 ist am ersten Teil 4 befestigt und druckt im verriegelten Zustand das zweite Teil 3 nach außen, so daß die Verriegelungsklappe 2 nicht betätigt werden kann.

Zum Entriegeln müssen zwei senkrecht aufeinander stehende Kräfte gleichzeitig ausgeübt werden:
Drücken des zweiten Teils 3 zum Körper (in Richtung A) gegen die Feder 7, Drücken der Verriegelungsklappe 2 (in Richtung B) gegen die Feder 10. Dann kann die Halterung (in Richtung C) aufgeklappt werden.

Damit das Funkgerät 1 sicher in der Halterung sitzt, weist das zweite Teil 3 an einer Innenwand eine Warze 8 auf, die in einer Vertiefung des Geräts einrastet. Die gegenüberliegende Innenwand weist eine elastische Polsterung 9, z.B. aus Filz, auf. Durch entsprechenden Kraftaufwand beim Herausziehen des Funkgeräts 1 wird die Polsterung 9 zusammengedrückt und die Warze 8 gleitet aus der Vertiefung des Geräts.

Es versteht sich, daß die erfindungsgemäße Halterung auf vielerlei Weise abgewandelt und an bestimmte Einsatzbedingungen bzw. an bestimmte Bediengeräte angepaßt werden kann. Beispielsweise ist es möglich, die Halterung in das Gehäuse des Bediengeräts zu integrieren, dergestalt, daß der halbschalenförmige Teil (3) integraler Bestandteil des Gehäuses des Bediengeräts ist und damit Halterung und Gehäuse eine Einheit bilden. Auch andere Verriegelsmechanismen z.B. unter Zurhilfenahme von Dauermagneten sind denkbar.

## Patentansprüche

1. Halterung für ein tragbares Bediengerät, welche Halterung an einem Brust- oder Schulter-Tragegeschirr befestigt ist, gekennzeichnet durch folgende Merkmale:

   - die Halterung besteht aus einem ersten Teil (4), welches am Tragegeschirr (6) befestigt ist, und einem zweiten halbschalenförmigen Teil (3) zur Aufnahme des Bediengeräts (1);

   - erstes Teil (4) und zweites Teil (3) sind an ihrem unteren Ende durch ein Scharnier (5) miteinander verbunden, derart, daß das zweite Teil um zwischen 60° und 90° vom ersten Teil wegklappbar ist;

   - das zweite Teil (3) weist an einer Außen-

seite eine großflächige Verriegelungs-klappe (2) auf, welche gegen den Druck einer ersten Feder (10) betätigbar ist und mit einem Bogen (12) in einem Haken (11) des ersten Teils (4) einrastet;
- eine zweite Feder (7) ist am ersten Teil (4) befestigt und drückt im verriegelten Zustand das zweite Teil (3) nach außen.

2. Kombination einer Halterung nach Anspruch 1 und eines ein Gehäuse aufweisenden tragbaren Bediengeräts.

3. Kombination nach Anspruch 2, dadurch gekennzeichnet, daß das zweite Teil (3) an einer Innenwand eine Warze (8) aufweist, welche in einer Vertiefung des Bediengeräts (1) einrastbar ist, und daß die gegenüberliegende Innenwand eine elastische Polsterung (9) aufweist.

4. Kombination nach Ansprüche 2 oder 3, dadurch gekennzeichnet, daß der halbschalenförmige Teil (3) integraler Bestandteil des Gehäuses des Bediengerätes (1) ist.

## Claims

1. A carrier for a portable control unit, which carrier is attached to a chest or shoulder harness, characterized by the following features:
- the carrier consists of a first part (4), which is attached to the harness (6), and a second shell-type part (3) to accommodate the control unit (1);
- the said first part (4) and the said second part (3) are connected to each other by means of a hinge (5) at their lower ends, such that the said second part can be folded away from the said first part by between 60° and 90°;
- on one external surface, the said second part (3) is provided with a large locking flap (2) which can be operated against the pressure of a first spring (10) and which engages a hook (11) of the said first part (4) with a bend (12);
- a second spring (7) is attached to the said first part (4) and pushes the said second part (3) outward in the locked condition.

2. A combination of a carrier as claimed in Claim 1 and a portable control unit provided with an enclosure.

3. A combination as claimed in Claim 2, characterized in that the said second part (3) has a button (8) on an internal wall which can be engaged in a recess in the control unit (1) and that the opposite internal wall is provided with an elastic padding (9).

4. A combination as claimed in Claims 2 or 3, characterized in that the said shell-type part (3) is an integral part of the enclosure of the control unit (1).

## Revendications

1. Support pour un appareil de service portatif, lequel support est fixé à un harnais de portage de poitrine ou d'épaule, caractérisé par les traits caractéristiques suivants :
- le support est composé d'une première pièce (4) qui est fixée au harnais de portage (6), et d'une deuxième partie (3) en forme de demi-coquille, destinée à recevoir l'appareil de service (1) ;
- la première partie (4) et la deuxième partie (3) sont reliées l'une à l'autre à leur extrémité inférieure, par une charnière (S), de manière que la deuxième partie puisse être rabattue d'un angle d'entre 60° et 90° dans le sens qui l'écarte de la première partie ;
- la deuxième partie (3) présente sur une face extérieure une palette de verrouillage (2) de grande surface qui peut être actionnée à l'encontre de la pression d'un premier ressort (10), et qui s'encliquette par une partie recourbée (12) dans un crochet (11) de la première partie (4) ;
- un deuxième ressort (7) est fixé à la première partie (4) et presse la deuxième partie (3) vers l'extérieur dans l'état verrouillé.

2. Combinaison d'un support selon la revendication 1 et d'un appareil de service portatif présentant un boîtier.

3. Combinaison selon la revendication 2, caractérisée en ce que la deuxième partie (3) présente sur une paroi intérieure un bouton (8) qui peut s'encliqueter dans une empreinte de l'appareil de service (1), et en ce que la paroi intérieure opposée présente un rembourrage élastique (9).

4. Combinaison selon la revendication 2 ou 3, caractérisée en ce que la partie (3) en forme de demi-coquille fait partie intégrante du boîtier de l'appareil de service (1).

FIG. 1

FIG. 2

FIG. 3